# EUROPEAN PATENT APPLICATION

(11) **EP 4 597 588 A1**
(43) Date of publication of application: **06.08.2025**
(21) Application number: 23887666.8
(22) Date of filing: 21.09.2023
(51) Int. Cl.: H01L 33/38, H01L 33/50, H01L 33/00, H01L 27/15

(54) **MICRO LED MICRO-DISPLAY CHIP AND MANUFACTURING METHOD THEREFOR**

(30) Priority: 09.11.2022 CN 202211400408
(71) Applicant: Raysolve Optoelectronics (Suzhou) Co., Ltd., Suzhou, Jiangsu 215000 (CN)
(72) Inventor: ZHANG, Xu, Suzhou, Jiangsu 215000 (CN); CHONG, Wing Cheung, Suzhou, Jiangsu 215000 (CN); ZHANG, Nao, Suzhou, Jiangsu 215000 (CN); ZHANG, Chao, Suzhou, Jiangsu 215000 (CN); ZENG, Hongtu, Suzhou, Jiangsu 215000 (CN)
(74) Representative: Murgitroyd & Company
(86) International application number: PCT/CN2023/120394
(87) International publication number: WO 2024/098972

(57) **Abstract**

Disclosed in the present application are a Micro LED micro-display chip and a manufacturing method therefor. The Micro LED micro-display chip comprises: a driving panel; a plurality of LED units, which are arranged on the driving panel, wherein the plurality of LED units are provided with a plurality of LED platforms corresponding to same on a one-to-one basis, and each LED unit can be separately driven by the driving panel; a fence structure, which is provided with a plurality of grid holes, wherein the plurality of grid holes are respectively arranged around the plurality of LED platforms, and a recessed area is formed between each LED platform and the corresponding grid hole; and a wavelength conversion layer, which is arranged on the fence structure and comprises a first wavelength conversion layer, wherein the first wavelength conversion layer is provided with a plurality of first wavelength conversion units, the first wavelength conversion units fill the corresponding recessed areas, the LED units emit first-color light, and the first wavelength conversion units convert the first-color light into second-color light.

## Description

The present application claims priority to Chinese Patent Application No. 202211400408.9, filed with the Chinese Patent Office on November 9, 2022 and entitled "MICRO LED MICRO-DISPLAY CHIP AND MANUFACTURING METHOD TEHREOF", which is incorporated herein by reference in its entirety.

### TECHNICAL FIELD

Embodiments of the present application relate to the field of LED display technologies, and more specifically, to a Micro LED micro-display chip and a manufacturing method thereof.

### BACKGROUND

The modern society has entered an information society and developed towards an intelligent society. Display is a key link for information exchange and intelligentization. Among many display technologies at present, the Micro LED display technology is an outstanding next-generation display technology and is widely concerned. The Micro LED display technology is a self-emitting display technology, in which arrayed micron-level LED units (also referred to as LED light emitting units) are integrated on an active addressing driver panel to implement separate control and lighting, so as to output a display image.

With the development of the Micro LED micro-display technology, miniaturization and high resolution of a display device such as an augmented reality (augmented reality, AR) display device, a virtual reality (virtual reality, VR) display device, a near-eye display (near-eye display, NED) device, and a head up display (head up display, HUD) device, are possible.

The Micro LED micro-display chip generally includes multiple LED self-emitting units. However, in a working process, light emitted by the LED units is relatively scattering or the wavelength conversion material is insufficient, so that wavelength conversion efficiency of a wavelength conversion layer in the Micro LED micro-display chip is relatively low.

### SUMMARY

Embodiments of the present application provides a Micro LED micro-display chip and a manufacturing method thereof. The following describes the aspects involved in the embodiments of the present application.

According to a first aspect, a Micro LED micro-display chip is provided, including a driver panel; multiple LED units arranged on the driver panel, wherein the multiple LED units comprises multiple LED mesas in a one-to-one correspondence with the multiple LED units, and each of the LED units is independently drivable by the driver panel; a grid structure having multiple grid holes, wherein the multiple grid holes are respectively provided around the multiple LED mesas, and recess areas are formed between the LED mesas and the respective grid holes; a wavelength conversion layer provided on the grid structure, wherein the wavelength conversion layer comprises a first wavelength conversion layer, the first wavelength conversion layer comprises multiple first wavelength conversion units, the first wavelength conversion units fill the recess areas corresponding to the first wavelength conversion units , the LED units are configured to emit first color light, and the first wavelength conversion units are configured to convert the first color light into second color light.

In a possible implementation, a first filter layer is provided on the first wavelength conversion layer, and the first filter layer is configured to filter out other color light and pass the second color light.

In a possible implementation, the wavelength conversion layer further comprises a second wavelength conversion layer, the second wavelength conversion layer comprises multiple second wavelength conversion units, the second wavelength conversion units fill the recess areas corresponding to the second wavelength conversion units, and the second wavelength conversion units are configured to convert the first color light into third color light.

In a possible implementation, a second filter layer is provided on the second wavelength conversion layer, and the second filter layer is configured to filter out other color light and pass the third color light.

In a possible implementation, the wavelength conversion layer further comprises a third wavelength conversion layer, the third wavelength conversion layer comprises multiple third wavelength conversion units, the third wavelength conversion units fill the recess areas corresponding to the third wavelength conversion units, and the third wavelength conversion units are configured to convert the first color light into fourth color light.

In a possible implementation, a third filter layer is provided on the third wavelength conversion layer, and the third filter layer is configured to filter out other color light and pass the fourth color light.

In a possible implementation, a material of the wavelength conversion layer comprises wavelength conversion particles and a photoresist, and the wavelength conversion particles are phosphor powder and/or quantum dots.

In a possible implementation, a top surface of the wavelength conversion layer is flush with or lower than a top surface of the grid structure.

In a possible implementation, a reflective layer is provided on a surface of the grid structure, and the reflective layer is provided on side walls of the grid holes and a top surface of the grid structure.

In a possible implementation, a size of each of the LED units is in a range of 0.1-10 microns.

According to a second aspect, a method for manufacturing a Micro LED micro-display chip is provided, including: providing a driver panel; forming multiple LED units on the driver panel, wherein the multiple LED units comprises multiple LED mesas in a one-to-one correspondence with the multiple LED units, and each of the LED units is independently drivable by the driver panel; forming a grid structure having multiple grid holes, wherein the multiple grid holes are respectively provided around the multiple LED mesa, and recess areas are formed between the LED mesas and the respective grid holes; forming a wavelength conversion layer on the grid structure, wherein the wavelength conversion layer comprises a first wavelength conversion layer, the first wavelength conversion layer comprises multiple first wavelength conversion units, the first wavelength conversion units fill the recess areas corresponding to the first wavelength conversion units, the LED units are configured to emit first color light, and the first wavelength conversion units are configured to convert the first color light into second color light.

In a possible implementation, the forming the wavelength conversion layer on the grid structure comprises: forming a first wavelength conversion material layer on the grid structure; and performing exposure and development on the first wavelength conversion material layer according to a patterned mask to form the first wavelength conversion layer..

In a possible implementation, the method further includes: forming a first filter layer on the first wavelength conversion layer, wherein the first filter layer is configured to filter out other color light and pass the second color light.

In a possible implementation, the forming the wavelength conversion layer on the grid structure comprises: forming a second wavelength conversion material layer on the grid structure; and performing exposure and development on the second wavelength conversion material layer according to a patterned mask to form a second wavelength conversion layer, wherein the second wavelength conversion layer comprises multiple second wavelength conversion units, the second wavelength conversion units fill the recess areas corresponding to the second wavelength conversion units, and the second wavelength conversion units are configured to convert the first color light into third color light..

In a possible implementation, the method further includes: forming a second filter layer on the second wavelength conversion layer, wherein the second filter layer is configured to filter out other color light and pass the third color light.

In a possible implementation, the forming the wavelength conversion layer on the grid structure comprises: forming a third wavelength conversion material layer on the grid structure; and performing exposure and development on the third wavelength conversion material layer according to a patterned mask to form a third wavelength conversion layer, wherein the third wavelength conversion layer comprises multiple third wavelength conversion units, the third wavelength conversion units fill recess areas corresponding to the third wavelength conversion units, and the third wavelength conversion units are configured to convert the first color light into fourth color light.

In a possible implementation, the method further includes: forming a third filter layer on the third wavelength conversion layer, wherein the third filter layer is configured to filter out other color light and pass the fourth color light.

In a possible implementation, before the forming the wavelength conversion layer on the grid structure, the method further comprises: forming a reflective layer on a surface of the grid structure having the multiple grid holes.

In a possible implementation manner, the forming the reflective layer on the surface of the grid structure comprises: forming a reflective material layer on the multiple LED mesas and on the grid structure; etching the reflective material layer on the multiple LED mesas to form the reflective layer on sidewalls of the grid holes and on a top surface of the grid structure.

In a possible implementation manner, the forming the multiple LED units on the driver panel comprises: forming an LED epitaxial layer on the driver panel; and etching the LED epitaxial layer according to a pattern-mask designed MESA pattern, to form the multiple LED units.

The Micro LED micro-display chip in this embodiment of the present application includes multiple LED units, a grid structure having multiple grid holes, and a wavelength conversion layer. The multiple LED units have one-to-one corresponding multiple LED mesas, and the multiple grid holes are respectively provided around the multiple LED mesas, and a recess area is formed between the LED mesas and corresponding grid holes, a wavelength conversion layer is provided and a grid structure, and a first wavelength conversion unit in the wavelength conversion layer may be corresponding filled in a corresponding recess area. In one aspect, in this solution, the first wavelength conversion unit directly covers the LED unit, and fills a corresponding recess area, so that the wavelength conversion unit is closer to the LED unit. Light output from a light plane and a side of the LED unit can be effectively used, and the filled wavelength conversion material is also more, thereby improving wavelength conversion efficiency. On the other hand, the grid structure is provided around the LED unit, so as to prevent a sidewall of the LED unit from leaking light, and may gather and collimate light emitted by the LED, thereby further improving wavelength conversion efficiency of the Micro LED micro-display chip.

### BRIEF DESCRIPTION OF DRAWINGS

By describing the embodiments of the present application in more detail with reference to the accompanying drawings, the foregoing and other objects, features, and advantages of the present application will become more apparent. The accompanying drawings are used to provide a further understanding of the embodiments of the present application, constitute a part of the specification, and are used together with the embodiments of the present application to explain the present application, which does not constitute a limitation on the present application. In the accompanying drawings, the same reference numerals represent the same components or steps.
FIG. 1 is a possible schematic structural diagram of a Micro LED micro-display chip according to an embodiment of the present application.
FIG. 2 is another possible schematic structural diagram of the Micro LED micro-display chip shown in FIG. 1.
FIG. 3 is a schematic flowchart of a method for manufacturing a Micro LED micro-display chip according to an embodiment of the present application.
FIG. 4 is a schematic structural diagram of a substrate and an epitaxial layer according to an embodiment of the present application.
FIG. 5 is a schematic structural diagram showing that a bonding layer is provided on an upper part of an epitaxial layer shown in FIG. 4.
FIG. 6 is a schematic structural diagram of a driver panel shown in FIG. 2.
FIG. 7 is a schematic structural diagram showing that a bonding layer is provided on an upper part of a driver panel shown in FIG. 6.
FIG. 8 is a schematic structural diagram of bonding a driver panel to an epitaxial layer according to an embodiment of the present application.
FIG. 9 is a schematic structural diagram showing that the epitaxial layer shown in FIG. 8 is thinned.
FIG. 10 is a schematic structural diagram of an LED unit showing that an epitaxial layer shown in FIG. 9 is etched.
FIG. 11 is a schematic structural diagram of a first electrode layer obtained by etching the bonding layer shown in FIG. 10.
FIG. 12 is a schematic structural diagram showing that a passivation layer is provided outside an LED unit shown in FIG. 11.
FIG. 13 is a schematic structural diagram showing that a second electrode layer is provided on an upper part of an LED unit shown in FIG. 12.
FIG. 14 is a schematic structural diagram showing that an etching barrier layer is provided on multiple LED units shown in FIG. 13.
FIG. 15 is a schematic structural diagram showing that a grid material layer is provided on the etching barrier layer shown in FIG. 14.
FIG. 16 is a schematic structural diagram of a grid structure having multiple grid holes obtained by etching a grid material layer in FIG. 15.
FIG. 17 is a schematic structural diagram showing that a reflective layer is provided on multiple bowl-shaped grid structures shown in FIG. 16.
FIG. 18 is a schematic structural diagram showing that a sacrificial layer is provided on the reflective layer shown in FIG. 17.
FIG. 19 is a schematic structural diagram showing that sacrificial layers in the upper parts of multiple grid holes shown in FIG. 18 are removed.
FIG. 20 is a schematic structural diagram showing that the reflective layers in the upper parts of the multiple grid holes shown in FIG. 19 are etched.
FIG. 21 is a schematic structural diagram showing that sacrificial layers on top of multiple grid structures shown in FIG. 20 are removed.
FIG. 22 is a schematic structural diagram showing that a first wavelength conversion layer is formed on the grid structure shown in FIG. 21.
FIG. 23 is a schematic structural diagram showing that a mask layer is provided on the first wavelength conversion layer shown in FIG. 22.
FIG. 24 is a schematic structural diagram showing the first wavelength conversion layer shown in FIG. 23 processed by exposure and development.
FIG. 25 is a schematic structural diagram showing that a second wavelength conversion unit and a third wavelength conversion unit are formed on a basis of FIG. 24.
FIG. 26 is a schematic structural diagram showing that a first filter layer is formed on the wavelength conversion layer shown in FIG. 25.
FIG. 27 is a schematic structural diagram showing that a mask layer is formed on the first filter layer shown in FIG. 26.
FIG. 28 is a schematic structural diagram showing that the first filter layer shown in FIG. 27 is etched.
FIG. 29 is a schematic structural diagram showing that the mask layer shown in FIG. 28 is removed.
FIG. 30 is a schematic structural diagram showing that a second filter unit and a third filter unit are formed on a basis of FIG. 29.
FIG. 31 is a schematic structural diagram of a Micro LED micro-display chip shown in FIG. 30 that does not include a reflective layer.
FIG. 32 is a schematic structural diagram of a display apparatus according to an embodiment of the present application.
FIG. 33 is a schematic structural diagram of an electronic device according to an embodiment of the present application.

### DESCRIPTION OF EMBODIMENTS

The following clearly and completely describes the technical solutions in the embodiments of the present application with reference to the accompanying drawings in the embodiments of the present application. Apparently, the described embodiments are only some rather than all the embodiments of the present application.

It is noted that it should be specifically noted that, in the description of the present application, the terms "on" should be interpreted in the broadest sense, meaning that the term is interpreted as "a component may be provided on another component in a direct contact manner, or an intermediate component or layer may exist between the component and the other component".

In addition, for ease of description, the present application may further use, for example, "on", "under", "above", "below", "upper", "lower" describe the spatial relationship between one element or component and another element or component shown in the accompanying drawings. In addition to the orientations described in the figures, the spatial relative terminology is intended to cover different orientations of the apparatus in use or operation. The device may be oriented in another manner (rotated by 90 degrees or in another direction), and the description of spatial relationship used in the present application may be interpreted accordingly.

The term "layer" used in the present application refers to a material part that includes an area of a specific thickness. The layer may extend over the entire lower or upper structure, or may extend over a partial range of the lower or upper structure. In addition, the layer may be an area of a homogeneous or heterogeneous continuous structure, whose thickness is less than the thickness of the continuous structure. For example, a layer may be located between a top surface and a bottom surface of a continuous structure or between any pair of horizontal planes between the top surface and the bottom surface. The layer may extend horizontally, vertically, and/or along a conical surface.

The modern society has entered an information society and developed towards an intelligent society. Display is a key link for information exchange and intelligentization.

In recent years, because of low power consumption, fast response, long life span and high optical efficiency, Micro-LED is considered as an "ultimate display technology" that subverts the industry after LCD and OLED, and is also the mainstream trend and development direction of display technology in the future. The leading scientific and technological organizations have increased their investment. Although the attention in this field continues to rise, it is undeniable that, as a new technology, there are still many challenges and bottlenecks in the high brightness, high resolution and single-piece full color of Micro-LED.

In many display technologies at present, the Micro LED display technology is considered as an outstanding next-generation display technology, and is widely concerned. The Micro LED display technology is a self-emitting display technology, in which arrayed micron-level LED units (also referred to as LED light emitting units) are integrated on an active addressing driver panel to implement separate control and lighting so as to output a display image.

The Micro LED display has many advantages such as self-emitting, high efficiency, low power consumption, high integration, and high stability, a small size, a high flexibility, and is easy to disassemble and combine, and can be used in any existing display applications of any sizes.

Micro LED is also referred to as a miniature light emitting diode, generally having a size of hundreds of microns. With the development of the Micro LED micro-display technology, miniaturization and high resolution of a display device such as an augmented reality (augmented reality, AR) display device, a virtual reality (virtual reality, VR) display device, a near-eye display (near-eye display, NED) device, and a head up display (head up display, HUD) device become possible. In these application scenarios, a size of the Micro LED is generally in the range of 0.1-10 microns.

The Micro LED micro-display chip generally includes multiple LED self-emitting units. However, in a working process, light emitted by the LED unit is relatively scattering or the wavelength conversion material is insufficient, so that wavelength conversion efficiency of a wavelength conversion layer in the Micro LED micro-display chip is relatively low.

To solve the foregoing problem, the Micro LED micro-display chip in this embodiment of the present application includes multiple LED units, a grid structure having multiple grid holes, and a wavelength conversion layer. The multiple LED units are in one-to-one correspondence with multiple LED mesas, and the multiple grid holes are respectively provided around the multiple LED mesas, and recess areas are formed between the LED mesas and corresponding grid holes, a wavelength conversion layer is provided on the grid structure, and a first wavelength conversion unit in the wavelength conversion layer may fill a corresponding recess area. In one aspect of this solution, the first wavelength conversion unit directly covers the LED unit, and fills a corresponding recess area, so that the wavelength conversion unit is closer to the LED unit. Therefore, light output from a light emitting surface and a side surface of the LED unit can be effectively used, and the filled wavelength conversion material is also increased, thereby improving wavelength conversion efficiency. On the other hand, the grid structure is provided around the LED units, so as to prevent a sidewall of the LED unit from leaking light, and may gather and collimate light emitted by the LED unit, thereby further improving wavelength conversion efficiency of the Micro LED micro-display chip.

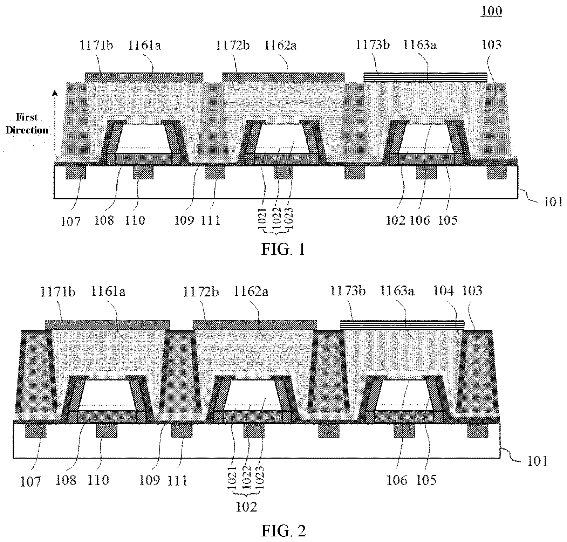

FIG. 1 is a schematic structural diagram of a possible cross-section of a Micro LED micro-display chip according to an embodiment of the present application. As shown in FIG. 1, the Micro LED micro-display chip 100 may include a driver panel 101, multiple LED units 102, a grid structure 103 having multiple grid holes, and a wavelength conversion layer 116.

The multiple LED units 102 may be arranged on the driver panel 101 in a regular or irregular manner as pixels of the Micro LED micro-display chip. The multiple LED units 102 may have multiple LED mesas that are in a one-to-one correspondence with the multiple LED units 102, and the LED units 102 may also be referred to as Micro LED units. A size of the LED units 102 is 0.1-10 microns. In a preferred solution, a size of the LED units 102 is less than 5 microns.

In some implementation manners, the LED unit 102 may be a micro light emitting diode, or may be a micro organic light emitting diode, where the micro light emitting diode is formed based on an inorganic semiconductor material. For example, the inorganic semiconductor material may be gallium nitride, aluminum gallium nitrogen, gallium arsenide, aluminum gallium indium phosphorus, or the like. The micro organic light emitting diode is formed based on an organic material. For example, the organic material may be a small molecule material, a polymer material, a phosphor material, or the like.

In some embodiments, the LED unit 102 may emit first color light, where the first color light includes but is not limited to any one of red light, green light, blue light, yellow light, or ultraviolet light.

In some embodiments, the multiple LED mesas may be trapezoidal. A sidewall of the LED mesa may be an oblique surface, and an included angle between the sidewall and the top surface of the LED mesa may be a blunt angle, so that a light focusing effect of the LED unit can be improved. It is understood that the multiple LED mesas may also be columnar. In this case, an angle between a sidewall and a top surface of the LED mesa is a right angle.

A grid material layer is provided on the multiple LED units 102, where the grid material layer may be a grid structure 103 having multiple grid holes, and the grid structure 103 having multiple grid holes includes multiple grid holes and a grid structure 103. The multiple grid holes may be arranged in a regular or irregular manner. The grid holes may be provided in a one-to-one correspondence with the multiple LED units 102. The multiple grid holes may be provided around the multiple LED mesas, so that recess areas are formed between the LED mesas and corresponding grid holes, and the recess areas may be in a bowl shape or a horn shape. In some embodiments, to improve uniformity of light emission of the LED units 102, the LED units 102 may be provided at center positions of the grid holes, so that the first color light may pass through the grid holes evenly.

In some embodiments, the grid holes in the grid material layer may be formed by dry etching, for example, a side wall of a grid hole may be etched into a slope, and an angle between the side wall of the grid hole and a top surface of the grid structure is a blunt angle. As an example, as shown in FIG. 1, in a first direction, a size of a cross-section of a grid hole may gradually increase, where the cross-section of the grid hole is a cross-section parallel to the light emitting surface 106. Generally, the cross-section may be a circular cross-section or a square cross-section, or the cross-section may be an irregular shape cross-section. A structure of the grid hole may be a bowl-like structure or a horn-like structure, so that emission light of the LED can be collimated.

It is noted that in this embodiment of the present application, a material of the grid structure 103 having multiple grid holes is not specifically limited. For example, a material of the grid structure 103 having multiple grid holes may include an organic resin, an organic black matrix photoresist, a color filter photoresist, or a polyimide.

In some embodiments, a sidewall of the LED mesa may be provided as an inclined side wall, and an angle between the sidewall and the top surface of the LED mesa may be a blunt angle, and a sidewall of a grid hole is formed as an inclined side wall by etching, and an angle between the sidewall of the grid hole and the top surface of the grid structure is a blunt angle. With the combination of the inclined side wall of the LED mesa and the inclined side wall of the grid hole, so that light is reflected multiple times on the inclined side walls of the two, thereby further improving brightness of the LED unit.

The wavelength conversion layer 116 is provided on the grid structure 103. The wavelength conversion layer 116 includes a first wavelength conversion layer 1161, the first wavelength conversion layer 1161 may include multiple first wavelength conversion units 1161a, and the first wavelength conversion units 1161a fill corresponding recess areas. The first wavelength conversion unit 1161a may fill at least a part of the grid holes, or may fill all the grid holes. The first wavelength conversion unit 1161a may convert the first color light emitted by the LED unit 102 into the second color light. It is understood that the first color light is different from the second color light.

In some embodiments, the multiple wavelength conversion layers 116 may completely cover the multiple LED units 102. It is noted that the orthographic projections of the first wavelength conversion unit 1161a and the LED unit 102 may completely overlap with each other, or the orthographic projection of the LED unit 102 is located within the orthographic projection of the first wavelength conversion unit 1161a.

In some embodiments, the wavelength conversion layer 116 directly covers the LED unit 102, which have many advantages. According to a first aspect, the wavelength conversion layer 116 covers all over the LED unit 102, so that light from both the light emitting side and the side wall of the LED unit 102 can be effectively used, thereby fully using light output of the LED unit 102. According to a second aspect, the wavelength conversion layer 116 may provide protection for the LED unit 102 and the wavelength conversion layer 116 does not fall off easily, thereby improving a yield. In addition, a distance between the wavelength conversion layer 116 and the LED unit 102 is minimized, thereby improving light conversion efficiency of the Micro LED micro-display chip.

In some embodiments, the top surface of the wavelength conversion layer 116 may be flush with or lower than the top surface of the grid structure 103. In a preferred solution, a top surface of the wavelength conversion layer 116 may be flush with the top surface of the grid structure 103. The flush structure can not only effectively prevent optical crosstalk between adj acent LED units 102, but also ensure flatness and stability of the Micro LED micro-display chip structure, facilitating a subsequent production process.

In some embodiments, the size of the LED unit 102 may be in a range of 1 to 2 microns, and the depth between the top surface of the grid structure 103 and the light-emitting surface of the LED unit 102 is in a range of 2 to 4 microns. That is, the depth between the top surface of the grid structure 103 and the light output surface of the LED unit 102 is about 1 to 2 times of the LED size. Therefore, both the light conversion efficiency and the brightness of the Micro LED micro-display chip can be ensured.

It is noted that a size of the LED unit 102 refers to a size of a light emitting surface of the LED unit 102. As an example, when the LED unit 102 is a cylinder, the size of the light emitting surface of the LED unit 102 is a diameter of the cylinder. In another example, when the LED unit 102 is a cube, the size of the light emitting surface of the LED unit 102 is a side length of the cube.

In some embodiments, a material of the wavelength conversion layer 116 includes wavelength conversion particles and a photoresist. The wavelength conversion particles may be, for example, phosphor powder and/or quantum dots. This is not specifically limited in this embodiment of the present application. For example, the quantum dots may be a colloid quantum dots. The wavelength conversion layer 116 may be obtained by using an exposure and development process, which is simpler and more controllable.

In some embodiments, because the grid structure 103 surrounds the wavelength conversion layer 116, the wavelength conversion layer 116 may not be completely cured to the bottom (which may refer to near the bottom of the LED unit 102) during exposure, further, the concentration of the wavelength conversion particles at the bottom may be increased to improve wavelength conversion efficiency. For example, compared with a conventional solution in which the concentration of the wavelength conversion particles is up to 150mg/ml (about 40%), in the present invention, the concentration of the wavelength conversion particles can be increased to 300mg/ml (about 80%), which significantly improves the wavelength conversion efficiency of the Micro LED micro-display chip.

It is noted that the photoresist in this embodiment of the present application includes but is not limited to Overcoat glue, SU8 (near ultraviolet negative photoresist), benzocyclobutene (benzocyclobutene, BCB), or the like, and may be SiO2, Al2O3, Si3N4, or the like.

It is noted that the phosphor powder may be yttrium aluminum garnet, cerium phosphor, (oxygen) nitride phosphor, silicate phosphor, fluoride phosphor activated by Mn4+, or the like. The quantum dots may include one of or a combination of CdSe, CdS, CdZnSe, CdZnS, CdZnSeS, ZnSeS, ZnSe, CuInS, CuInSe, InP, InZnP, and perovskite quantum dots. This is not specifically limited in the present application.

In some embodiments, because the first wavelength conversion unit 1161a of the wavelength conversion layer 116 fills in the grid hole, the grid structure 103 can support the wavelength conversion layer 116, so that the wavelength conversion layer 116 can be thicker, and thus the light conversion efficiency can be greatly improved. In addition, a side surface of the wavelength conversion layer 116 is partially surrounded by the grid structure 103, so that a contact area increases, and adhesion can be increased, thereby improving a yield and enlarging a process window.

In some embodiments, the wavelength conversion layer 116 may include the first wavelength conversion layer 1161 and a second wavelength conversion layer 1162. The second wavelength conversion layer 1162 includes multiple second wavelength conversion units 1162a, and the first wavelength conversion units 1161a and the second wavelength conversion units 1162a fill different grid holes. That is, the first wavelength conversion units 1161a fills corresponding recessed areas, and the corresponding recessed areas include some of the grid holes. The second wavelength conversion units 1162a may fill corresponding remaining recessed areas, and the remaining recessed areas may be all the remaining grid holes, or may be some of the remaining grid holes. The second wavelength conversion units 1162a may convert the first color light into the third color light.

In some embodiments, the wavelength conversion layer 116 further includes a third wavelength conversion layer 1163. The third wavelength conversion layer 1163 comprises multiple third wavelength conversion units 1163a. The first wavelength conversion units 1161a, the second wavelength conversion units 1162a, and the third wavelength conversion units 1163a fill corresponding recess areas, that is, filling different grid holes. That is, the first wavelength conversion units 1161a fill a part of the grid holes, the second wavelength conversion units 1162a fill a part of remaining grid holes, and the third wavelength conversion units 1163a fill all or part of remaining grid holes. The third wavelength conversion units 1163a may convert the first color light into fourth color light.

It may be understood that both the second wavelength conversion units 1162a and the third wavelength conversion units 1163a are similar to the first wavelength conversion units 1163a in terms of shape, construction, and size relative to the grid hole, and also have the same beneficial effects as those of the first wavelength conversion units 1161a. Details are not described herein again.

In some embodiments, the material of the first wavelength conversion units 1161a includes photoresist, quantum dots, and/or phosphor. The material of the second wavelength conversion units 1162a includes photoresist, quantum dots, and/or phosphor. The material of the third wavelength conversion units 1163a includes photoresist, quantum dots, and/or phosphor.

It is understood that the first color light, the second color light, the third color light, and the fourth color light may be different from each other.

It is understood that wavelengths of the second color light, the third color light, and the fourth color light may be longer than the wavelength of the first color light.

It is understood that if the first color light is light of a wavelength required for implementing micro-display, a wavelength conversion layer corresponding to the light of the wavelength may be omitted. The following uses an example in which the first wavelength conversion layer 1161 is a red-light wavelength conversion layer, the second wavelength conversion layer 1162 is a green-light wavelength conversion layer, and the third wavelength conversion layer 1163 is a blue-light wavelength conversion layer.

For example, if the first color light emitted by the LED unit 102 is blue light, the first wavelength conversion layer 1161 is a red-light wavelength conversion layer, and the second wavelength conversion layer 1162 is a green-light wavelength conversion layer. The corresponding blue-light wavelength conversion layer may be omitted.

For another example, if the first color light emitted by the LED unit 102 is ultraviolet light, the first wavelength conversion layer 1161 is a red-light wavelength conversion layer, the second wavelength conversion layer 1162 is a green-light wavelength conversion layer, and the third wavelength conversion layer 1163 is a green-light wavelength conversion layer. It is understood that, corresponding to the above wavelength conversion layers, the first wavelength conversion units 1161a are red, the second wavelength conversion units 1162a are green, and the third wavelength conversion units 1163a are blue.

In some embodiments, the first wavelength conversion layer 1161, the second wavelength conversion layer 1162, and the third wavelength conversion layer 1163 may be randomly corresponding to R, G, B (red, green, blue).

In some embodiments, the filter layer 117 may be provided on the wavelength conversion layer 116.

In some embodiments, the material of the filter layer 117 includes but is not limited to an organic color filter photoresist, a Bragg distributed reflector, or the like.

In some embodiments, the pattern of the filter layer 117 may be formed by any process, such as etching and transferring.

In some embodiments, the filter layer 117 includes a first filter layer 1171, where the first filter layer 1171 includes multiple first filter units 1171b respectively corresponding to the first wavelength conversion units 1161a. The first filter units 1171b are configured to filter out other color light and allow only the second color light to pass.

In some embodiments, the filter layer 117 may further include a second filter layer 1172, where the second filter layer 1172 includes multiple second filter units 1172b respectively corresponding to the second wavelength conversion units 1162a. The second filter units 1172b are configured to filter out other color light and allow only the third color light to pass.

In some embodiments, the filter layer 117 includes a third filter layer 1173, where the third filter layer 1173 includes multiple third filter units 1173b respectively corresponding to the third wavelength conversion units 1163a. The third filter units 1173b are configured to filter out other color light and allow only the fourth color light to pass.

In some embodiments, the filter units in the filter layer 117 may be fabricated after the wavelength conversion units in the wavelength conversion layer 116 are successively fabricated. Compared with a conventional solution in which wavelength conversion units and filter units are alternately fabricated, this solution can ensure flatness of the structure and facilitate subsequent preparation of another wavelength conversion unit.

In some embodiments, an etching barrier layer may be provided on a sidewall and a top surface of the LED mesas, and the etching barrier layer 107 may cover the multiple LED units 102 to prevent etching damage to the LED mesas or the second electrode layer 109. In addition, the etching barrier layer 107 may be transparent to the light emitted by the LED units 102. Therefore, the etching barrier layer 107 has sufficient transparency, and may be generally made of a material such as silicon dioxide, silicon nitride, and aluminum oxide.

Referring to FIG. 1, it is noted that the etching barrier layer 107 is a continuous film layer structure located below the grid material layer and above the LED units. The etching barrier layer 107 includes an etching barrier layer on the LED mesas and an etching barrier layer on the second electrode layer 109.

In some embodiments, the thickness of the etching barrier layer 107 may be, for example, 300-800nm. Certainly, the thickness of the etching barrier layer 107 may also be determined according to a specific requirement.

In some embodiments, the etching barrier layer 107 may include, for example, an adhesive layer, a barrier layer, and the like that are sequentially provided, where a material of the adhesive layer may be, for example, a metal material with good adhesion, such as chromium Cr, thereby improving an adhesive performance of the etching barrier layer 107, and avoiding detachment of the etching barrier layer 107. The material of the barrier layer is, for example, a non-reactive material that does not react with the etching gas, such as platinum Pt, so as to protect the LED unit 102 from being etched.

Referring to FIG. 2, in some embodiments, a reflective layer 104 may be provided on a surface of a grid structure 103 having multiple grid holes. The reflective layer 104 may not only effectively block light leakage from the sidewall of the LED unit 102, but also reflect light emitted by the LED unit 102. Furthermore, the grid structure 103 provided with the reflective layer 104 further focuses and collimates light reflected by the reflective layer 104 and light emitted by the LED unit 102, thereby further improving wavelength conversion efficiency of the wavelength conversion layer 116.

In some embodiments, the reflective layer 104 may be formed based on the grid structure 103, so as to avoid processing in a small gap between the LED units 102 of the Micro LED micro-display chip, thereby greatly reducing processing difficulty, enlarging a process window, and improving a processing yield, which may be applied to a product with high resolution and high pixel density.

In this embodiment of the present application, a material of the reflective layer 104 is not specifically limited. In some embodiments, the reflective layer 104 may be made of an organic material, including but not limited to a high-reflectance organic coating. The reflective layer 104 may also be made of an inorganic material, including but not limited to a metal material, such as Al, Cu, and Ag.

In some embodiments, the reflective layer 104 may be deposited onto the surface of the grid structure 103 in a manner such as atomic layer deposition (ALD), chemical vapor deposition (CVD), evaporation, sputtering, or the like.

In some embodiments, the reflective layer 104 may also be formed by dry etching, including but not limited to ion beam etch (ion beam etch, IBE) and inductively coupled plasma (inductively coupled plasma, ICP) etching. In some embodiments, by using the foregoing dry etching manner, the reflective layer 104 may be deposited and then etched integrally, so that the reflective layer 104 on the top of the LED unit 102 is etched completely. In addition, in the etching process, the reflective layer 104 has a plasma re-deposition effect, which causes thickening of the reflective layer 104 on the sidewall, enhances a reflective effect, and strengthens stability of the grid structure 103 and the overall structure. In this way, a preparation process can be simplified, and no additional photolithography step is required to make an etching mask. It is understood that, in a process of etching the reflective layer 104 in the grid hole, the etching barrier layer 107 may reduce damage to the LED mesa and the second electrode layer 109 caused by the etching process.

In some embodiments, the surface of the reflective layer 104 may be roughened to form a roughened surface. The roughened reflective layer 104 may increase a light reflecting capability.

It is noted that a roughening manner of the reflective layer 104 is not specifically limited in this embodiment of the present application. For example, a corrosion roughening process may be performed on the reflective layer 104. For example, a material of the reflective layer 104 is Al, and the corrosion roughening process may be performed on the reflective layer 104 by using hydrochloric acid (hydrogen chloride solution).

It is noted that a surface structure of the roughened reflective layer 104 is not specifically limited in this embodiment of the present application, and the roughened surface of the reflective layer 104 may be in an irregular concave-convex structure, or may be in a regular concave-convex structure. As an example, the roughened surface of the reflective layer 104 may be in the form of concave-convex of a fold line, for example, in the form of trapezoidal serration or serration. In another example, the coarse surface of the reflective layer 204 may also be in the form of concave-convex of a curved line, for example, in a wave shape.

In some embodiments, a passivation layer 105 may be deposited at the sidewall of the LED units 102. A material of the passivation layer 105 includes an inorganic material or an organic material. The inorganic material includes any one or combination of SiO2, Al2O3, ZrO2, TiO2, Si3N4, and HfO2. The organic material includes any one or combination of a black matrix photoresist, a color filter photoresist, a polyimide, a BANK (BANK), Overcoat gel, a near-ultraviolet negative photoresist, and a phenylcyclobutene.

In some embodiments, the driver panel 101 may include a substrate, a drive circuit, and multiple contacts connected to the drive circuit, and the LED units 102 are electrically connected to the multiple contacts. It is understood that a circuit layer including a complementary metal oxide semiconductor (complementary metal oxide semiconductor, CMOS) device, a TFT device, or the like may be further provided on the driver panel 101. The CMOS device or the TFT device may constitute a drive circuit. The substrate material may be a semiconductor material such as silicon, silicon carbide, gallium nitride, germanium, gallium arsenide, or indium phosphide, or may be a non-conductive material such as glass, plastic, or sapphire wafer.

In some embodiments, the multiple contacts include first electrode contacts 110 and a second electrode contact 111. The first electrode contacts 110 may be respectively electrically connected to corresponding LED units, and the second electrode contact 111 may be electrically connected to multiple LED units, to independently drive any LED unit of the multiple LED units 102 to emit light.

It is noted that the first electrode contact 110 may be an anode metal contact, and the second electrode contact 111 may be a cathode metal contact. The first electrode contact 110 is electrically connected to the first electrode layer 108, and the second electrode contact 111 is electrically connected to the second electrode layer 109. The second electrode contact 111 may be a common electrode contact of the multiple LED units 102. The first electrode contacts 110 may be respectively connected to corresponding LED units 102. In this embodiment of the present application, the LED units 102 may be independently applied with anode voltages by using the first electrode contacts 110, so as to have separate drive signals. In this way, light emission of each LED unit can be separately controlled.

In some embodiments, the connection structure of the LED units 102 may be co-cathode or co-anode or independent to each other. As an example, a common cathode structure may be implemented by connecting by a continuous cathode semiconductor layer. In another example, a common anode structure or an independent structure may be used, provided that the LED units 102 can be separately lit.

In some embodiments, there may also be another film layer, such as a bonding layer, between the LED unit 102 and the driver panel 101. The LED unit 102 may be adhered to or bond to a surface of the driver panel 101 by using a bonding layer.

In some embodiments, the LED units 102 include a first semiconductor layer 1021, a light emitting layer 1022, and a second semiconductor layer 1023 that are sequentially stacked on the driver panel 101. The light emitting layer 1022 and the second semiconductor layer 1023 may be provided discontinuously, but the bonding layer and the first semiconductor layer 1021 of the multiple LED units 102 may be provided continuously, so as to improve an adhesive force between the epitaxial structure layer and the driver panel 101, preventing the epitaxial structure layer from peeling off from the driver panel 101. Certainly, the present application is not limited thereto. In other embodiments, the bonding layer and the first semiconductor layer 1021 of the multiple LED units 102 may also be discontinuously provided, and details are not described herein again.

The second semiconductor layer 1023 is a n-type semiconductor layer, and correspondingly, the first semiconductor layer 1021 is a p-type semiconductor layer, the second electrode layer 109 is an N-electrode metal layer, and correspondingly, the first electrode layer 108 is a P-electrode metal layer. The first electrode contact 110 is an anode metal contact, that is, the first semiconductor layer 1021 is applied with an anode voltage. The second electrode contact 111 is a cathode metal contact, that is, the second semiconductor layer 1023 is applied with a cathode voltage. Therefore, the light emitting layer 1022 of the LED unit 102 may be driven to emit light.

It is noted that the materials of the first electrode layer 108 and the second electrode layer 109 may be indium tin oxide, Cr, Ti, Pt, Au, Al, Cu, Ge, or Ni.

It is noted that the first semiconductor layer 1021 may be a p-type semiconductor layer, and the p-type semiconductor layer may be formed in a manner of doping or ion implantation. For example, the first semiconductor layer 1021 may be a p-type GaN or InGaN layer. The first semiconductor layer 1021 may be a multi-layer structure. The second semiconductor layer 1023 may be a n-type semiconductor layer, and the n-type semiconductor layer may be formed in a manner of doping or ion implantation. For example, the second semiconductor layer 1023 may be a n-type GaN or InGaN layer. The second semiconductor layer 1023 may be a multi-layer structure. The light emitting layer 1022 is a layer where holes provided from the first semiconductor layer 1021 and electrons provided from the second semiconductor layer 1023 recombine so as to output light of a specific wavelength, and the light emitting layer 1022 may have a single quantum well structure or a multiple quantum well (MQW) structure where well layers and barrier layers are alternately stacked. The implanted ions may be H +, He+, N +, O+, F+, Mg+, Ar +, or the like.

In some embodiments, the first electrode layer 108 may be, for example, a part of a bonding layer, and a material of the bonding layer may be a conductive material, such as a metal material or a metal alloy material, specifically including Au, Sn, In, Cu, or Ti. Certainly, a material of the bonding layer may also be a non-conductive material, such as polyimide, polydimethylsiloxane, or Su-8 photoresist. It may be understood that if a material of the bonding layer is a non-conductive material, the bonding layer cannot be used as an anode together with the first semiconductor layer 1021. In this case, the first electrode layer 108 may be provided separately.

It is noted that the Micro LED micro-display chip in this embodiment of the present invention may further include an encapsulation layer. The encapsulation layer (not shown in the figure) may be provided on a side, of the reflective layer 104, away from the driver panel 101. In this embodiment, the reflective layer 104 is provided on a surface of the light-emitting grid structure 103. The surface of the reflective layer 104 may be concave and convex with the grid structure 103, and the encapsulation layer may be used to flat the Micro LED micro-display chip, so as to facilitate subsequent processing.

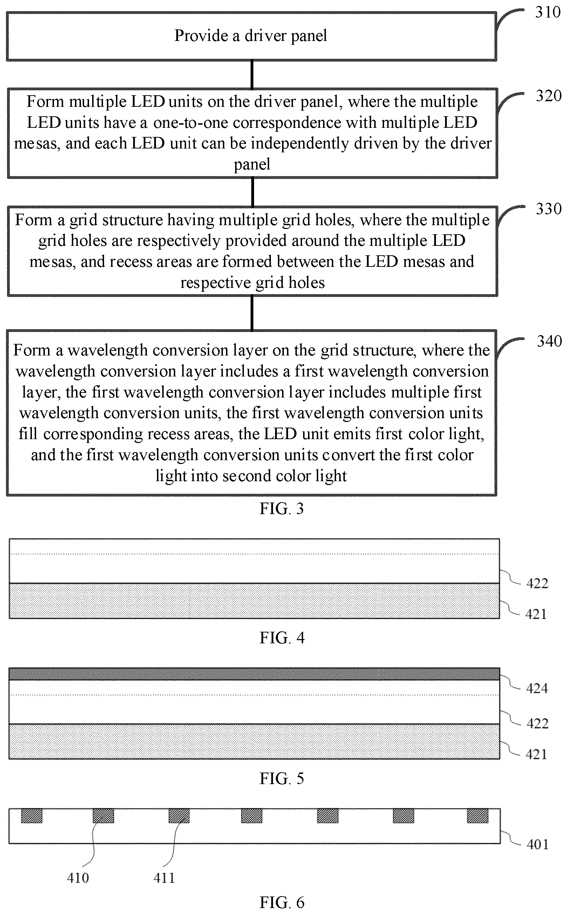

The foregoing describes the apparatus embodiments of the present application in detail with reference to FIG. 1 to FIG. 2. The following describes the method embodiments of the present application in detail with reference to FIG. 3. It is understood that the description of the method embodiment corresponds to the description of the apparatus embodiment. Therefore, for a part that is not described in detail, reference may be made to the foregoing apparatus embodiment.

FIG. 3 is a flowchart of a method for manufacturing a Micro LED micro-display chip according to an embodiment of the present application. As shown in FIG. 3, a method 300 for manufacturing a Micro LED micro-display chip includes the following steps S310 to S340.

In step S310, a driver panel is provided.

In step S320, multiple LED units are formed on the driver panel, where the multiple LED units have a one-to-one correspondence with multiple LED mesas, and each LED unit can be independently driven by the driver panel.

It is noted that, when the driver panel is provided, a substrate may be further provided, and an LED epitaxial layer may be formed on the substrate.

In some embodiments, based on providing the driver panel, a bonding layer may further be formed on the driver panel, so as to bond the driver panel to the LED epitaxial layer on the substrate. Further, the LED epitaxial layer on the driver panel may be etched to form multiple LED units. A manufacturing process of multiple LED units is described in detail in the following with reference to FIG. 4 to FIG. 31. Details are not described herein.

In step S330, a grid structure having multiple grid holes is formed, where the multiple grid holes are respectively provided around the multiple LED mesas, and recess areas are formed between the LED mesas and respective grid holes. That is, the multiple LED mesas and the grid structure may jointly form multiple recess areas that are in a one-to-one correspondence with locations of the multiple LED mesas.

In step S340, a wavelength conversion layer is formed on the grid structure, where the wavelength conversion layer includes a first wavelength conversion layer, the first wavelength conversion layer includes multiple first wavelength conversion units, the first wavelength conversion units fill corresponding recess areas, the LED unit emits first color light, and the first wavelength conversion units convert the first color light into second color light.

To better understand the Micro LED micro-display chip manufacturing method 300 in the embodiments of the present application, the following describes in detail the Micro LED micro-display chip manufacturing method 300 with reference to FIG. 4 to FIG. 31.

FIG. 4 to FIG. 31 are schematic structural diagrams of the Micro LED micro-display chip 400 of different stages in a preparation process. It is understood that the Micro LED micro-display chip 400 is corresponding to the foregoing Micro LED micro-display chip 100. For content that is not described in detail in this part, reference may be made to the description in part 100 of the Micro LED micro-display chip.

In some embodiments, referring to FIG. 4, a substrate 421 may be provided first, and an epitaxial layer 422 may be grown on the substrate 421.

Further, referring to FIG. 5, a bonding layer 424 may be formed on the epitaxial structure layer 422, and the bonding layer 424 may be configured to bond the LED epitaxial layer 422 on the substrate 421 to a driver panel 401 in the following text.

Referring to FIG. 6, according to step S310, the driver panel 401 is provided. The driver panel 401 may include a circuit layer including a complementary metal oxide semiconductor (CMOS) component, a TFT component, or the like. These CMOS devices or TFT devices may form a drive circuit in the driver panel 401. The driver panel 401 may further include multiple contacts connected to the drive circuit, and the multiple LED units 402 are electrically connected to the multiple contacts. It is understood that a sequence of providing the substrate 421 and the driver panel 401 is not specifically limited in this embodiment of the present application.

In some embodiments, the multiple contacts include first electrode contacts 410 and a second electrode contact 411. The first electrode contacts 410 may be respectively electrically connected to the LED units, and the second electrode contact 411 may be electrically connected to multiple LED units, to independently drive any LED unit of the multiple LED units to emit light.

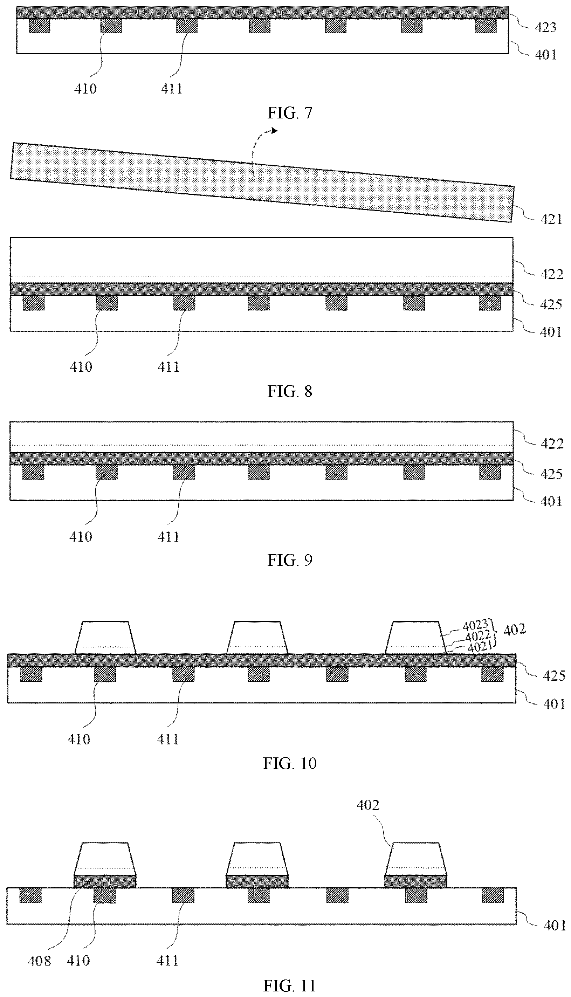

In some embodiments, referring to FIG. 7, a bonding layer 423 may be formed on the driver panel 401, and the bonding layer 423 may be configured to bond the driver panel 401 to the LED epitaxial layer 422 on the substrate 421.

In some embodiments, the bonding layer 423 and the bonding layer 424 may be formed in a deposition manner.

Referring to FIG. 8, the LED epitaxial layer 422 on the substrate 421 may be flipped, and the bonding layer 425 may be formed by fusing the bonding layer 423 and the bonding layer 424. Thus, the epitaxial layer 422 may be bonded to the driver panel 401, and then the substrate 421 may be peeled off from the LED epitaxial layer 422, so that the LED epitaxial layer 422 may be formed on the driver panel 401.

In some embodiments, the peeling method of the substrate 421 includes but is not limited to laser peeling, dry etching, wet etching, mechanical polishing, and the like.

In some embodiments, referring to FIG. 9, a thinning process may be performed on the flipped LED epitaxial layer 422. The thinning process includes dry etching, wet etching, or mechanical polishing.

In some embodiments, referring to FIG. 10, the LED epitaxial layer 422 may be etched according to a patterning mask design MESA pattern to form multiple LED units 402 having LED mesas, where the LED units 402 are functionalized step structures, and the LED units 402 include a first semiconductor layer 4021, a light emitting layer 4022, and a second semiconductor layer 4023. It is understood that the etching includes a dry etching or a wet etching.

In some embodiments, the first semiconductor layer 4021 may be a p-type semiconductor layer, and the p-type semiconductor layer may be formed in a manner of doping or ion implantation. For example, the first semiconductor layer 4021 may be a p-type GaN layer or an InGaN layer. The first semiconductor layer 4021 may be a multi-layer structure. The second semiconductor layer 4023 is a n-type semiconductor layer, where the n-type semiconductor layer may be formed in a manner of doping or ion implantation. For example, the second semiconductor layer 4023 may be a n-type GaN or InGaN layer. The second semiconductor layer 4023 may be a multi-layer structure. The light emitting layer 4022 is a layer where holes provided from the first semiconductor layer 4021 and electrons provided from the second semiconductor layer 4023 recombine so as to output light of a specific wavelength. The light emitting layer 4022 may have a single quantum well structure or a multiple quantum well (MQW) structure where well layers and barrier layers are alternately stacked.

In some embodiments, a bonding manner in this embodiment of the present application is metal bonding. Referring to FIG. 11, multiple first electrode layers 408 may be formed by etching the bonding layer 425, where the multiple first electrode layers 408 are provided in a one-to-one correspondence with the multiple LED units 402. In addition, adjacent LED units 402 cannot be electrically connected by using the first electrode layers 408. The first electrode layers 408 are electrically connected to the first electrode contacts 410, and a drive circuit in the driver panel 401 may separately apply anode voltages to the LED units 402 by using the first electrode contacts 410, so as to provide separate drive signals, to independently control light emission of each LED unit 402.

In some embodiments, the LED unit 402 may emit first color light, where the first color light includes but is not limited to any one of red light, green light, blue light, yellow light, or ultraviolet light.

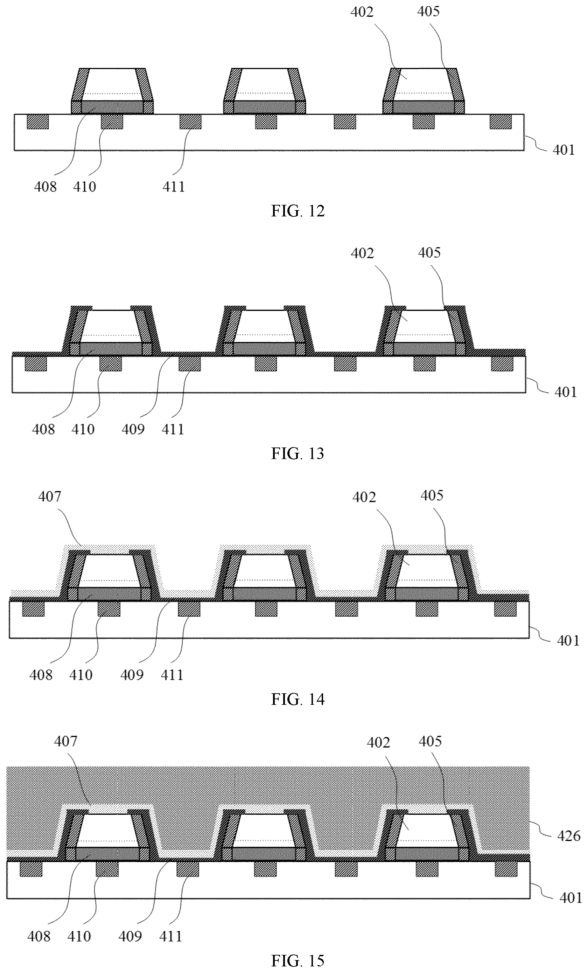

In some embodiments, referring to FIG. 12, the passivation layer 405 may be deposited on a sidewall surface of the LED unit 402. A material of the passivation layer 405 includes an inorganic material or an organic material.

In some embodiments, referring to FIG. 13, a second electrode layer 409 may be provided between the LED units 402, and the second electrode layer 409 may be located on the driver panel 401 and outside the passivation layer 405. The second electrode layer 409 may be connected to the first semiconductor layer of the multiple LED units 402. The second electrode layer 409 is a co-cathode electrode layer of the Micro LED micro-display chip, and the second electrode contact 411 may be connected to the second electrode layer 409, so that a conductive circuit may be formed between the second electrode contact 411 and the first electrode contacts 410, so as to drive the LED units 402 to emit light.

It is understood that, the second semiconductor layer 4023 may be a n-type semiconductor layer, and correspondingly, the first semiconductor layer 4021 may be a p-type semiconductor layer, the second electrode layer 409 may be an N-electrode metal layer, and correspondingly, the first electrode layer 408 may be a P-electrode metal layer.

Referring to FIG. 14, in some embodiments, an etching barrier layer 407 may be formed on sidewalls and top surfaces of the LED mesas. The etching barrier layer 407 covers of the multiple LED units 402 and a second electrode layer 409. It may be learned that the etch barrier layer 107 is a continuous film layer structure, and the etch barrier layer 407 may include an etch barrier layer on top of the LED mesas and an etch barrier layer on top of the second electrode 409. The etching barrier layer may prevent etching damage to the LED mesa or the second electrode layer 409. In addition, the etching barrier layer 407 may be transparent to the light emitted by the LED unit 402. That is, the etching barrier layer 407 has sufficient transparency, and may generally be made of a material such as silicon dioxide, silicon nitride, and aluminum oxide.

Referring to FIG. 15, a grid material layer 426 may be formed on the multiple LED units 402. A material of the grid material layer 426 may include, for example, an organic resin, an organic black matrix photoresist, a color photoresist, and a polyimide.

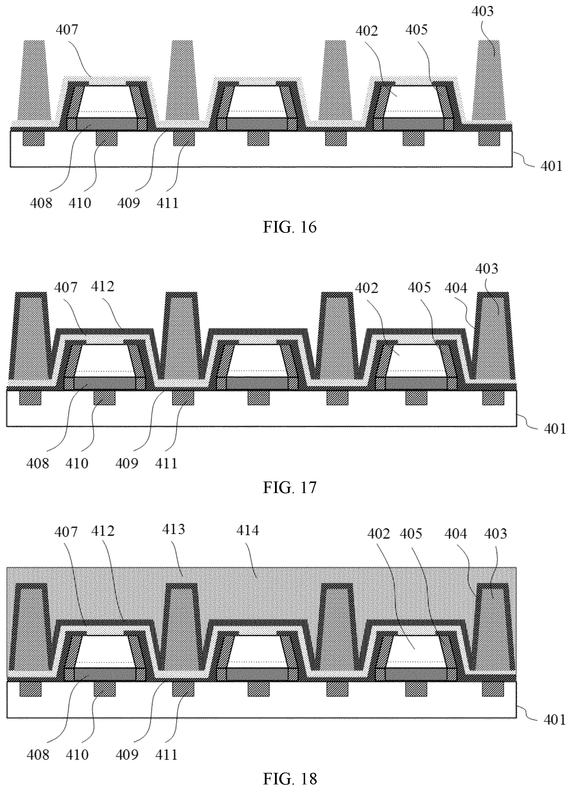

Referring to FIG. 16, a grid material layer 426 is etched to form a grid structure 403 having multiple grid holes. The multiple grid holes may be respectively provided around the multiple LED mesas, and recess areas are formed between the LED mesas and corresponding grid holes. It is understood that the multiple grid holes are provided in a one-to-one correspondence with the multiple LED units 402, so that light emitted by the LED units 402 may be emitted through the grid holes.

In some embodiments, the grid material layer 426 is provided on the etching barrier layer 407, the grid holes of the grid structure 403 may be formed by dry etching, and the grid holes expose the etching barrier layer 407. Because the etching barrier layer 407 covers on LED mesa and the second electrode layer 409, damage to the LED mesa and the second electrode layer 409 can be prevented in a process of etching the grid holes.

In some embodiments, a sidewall of the grid hole may be etched into a slope, and an angle between the sidewall of the grid hole and the top surface of the grid structure is a blunt angle. As an example, in a direction away from the LED unit 402 (as shown as the first direction in FIG. 1), a size of a cross-section of the grid hole gradually increases, where the cross-section of the grid hole is a cross-section parallel to the light emitting surface 406. Generally, the cross-section may be a circular cross-section or a square cross-section, or the cross-section may be an irregular shape cross-section. The shape of the grid hole may be a bowl-like structure or a horn-like structure.

In some embodiments, as shown in FIG. 17, to improve a reflection effect on light emitted by the LED unit 402, a reflective material layer may be formed on the multiple LED mesas and the grid structure 403. The reflective material layer may include a reflective layer 404 on the surface of the grid structure 403 and a reflective layer 412 exposed in the grid hole.

In some embodiments, the reflective material layer may be deposited onto the multiple LED mesa and grid structures 403 in a manner of, for example, atomic layer deposition (ALD), chemical vapor deposition (CVD), evaporation, sputtering, or the like. It is understood that the reflective material layer is located on the etching barrier layer 407.

In some embodiments, the reflective material layer on the multiple LED mesas may be etched to form a reflective layer 404 on sidewalls of the grid holes and on a top surface of the grid structure.

Referring to FIG. 18, in some embodiments, a sacrificial coating may further be formed on the reflective material layer before etching of the reflective material layer on the multiple LED mesas, and the sacrificial coating may include a sacrificial coating 413 on the top of the grid structure 403 and a sacrificial coating 414 exposed by the grid holes.

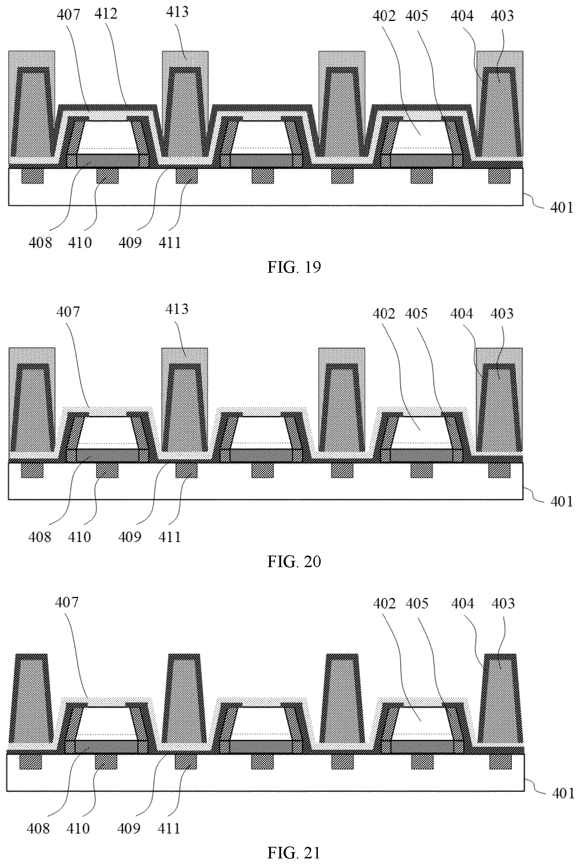

Referring to FIG. 19, the sacrificial coating 414 exposed by the grid holes may be removed first, and the sacrificial coating 413 on the grid structure 403 may be temporarily retained. The sacrificial layer 413 may be used to protect the reflective layer 404 on the surface of the grid structure 403 having the multiple grid holes, so as to prevent damage to the reflective layer 404 on the surface of the grid structure 403 having the multiple grid holes during etching of the reflective layer 412 exposed by the grid holes.

Referring to FIG. 20, the reflective layer 412 on top of the multiple LED mesas is etched to remove the reflective layer 412 on the multiple LED mesas to form a reflective layer 404. In the process of etching the reflective layer 412, the etching barrier layer 407 mentioned above may avoid etching damage to the LED mesas and the second electrode layer 409.

In some embodiments, the reflective layer 404 may also be formed by dry etching, where the dry etching includes but is not limited to ion beam etching (IBE) and inductively coupled plasma (ICP) etching. In some embodiments, by using the foregoing dry etching manner, the reflective layer 404 may be deposited and etched integrally, so that the reflective layer 104 on the top of the LED units 402 is etched completely. In addition, in the etching process, the reflective layer 404 has a plasma re-deposition (re-deposition) effect, which causes thickening of the reflective layer 404 on the sidewall, enhances a reflective effect, and strengthens stability of the grid structure 403 and the overall structure. In this way, a preparation process can be simplified, and no additional photolithography step is required to make an etching mask.

Referring to FIG. 21, after the reflective layer 404 is formed on the surface of the grid structure, the remaining sacrificial coating 413 on the grid structure 403 may be removed.

In some embodiments, forming a wavelength conversion layer 416 on the grid structure 403 includes forming a first wavelength conversion layer 4161, and the forming a first wavelength conversion layer 4161 includes forming a first wavelength conversion unit 4161a.

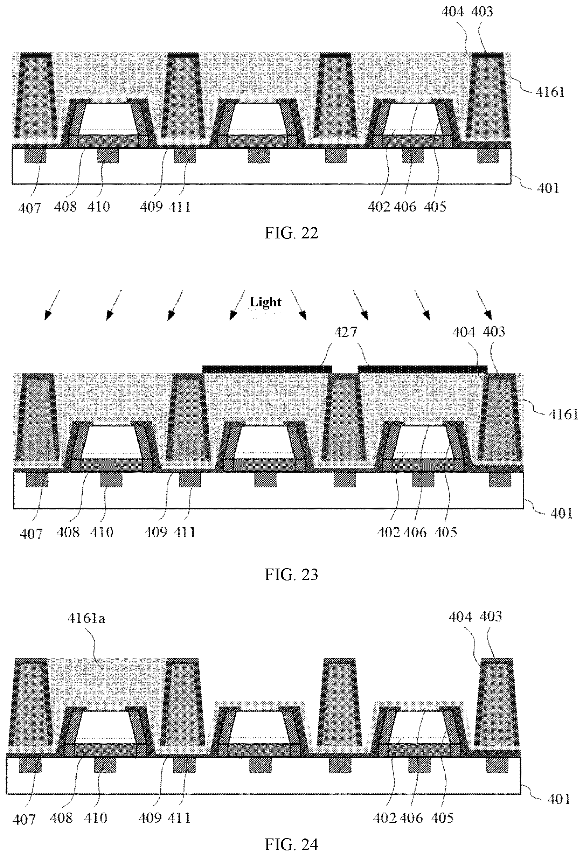

Referring to FIG. 22, the first wavelength conversion layer 4161 is first formed on the grid structure 403. For example, the first wavelength conversion layer 4161 may be formed by spin coating and drying. A material of the first wavelength conversion layer 4161 includes wavelength conversion particles and a photoresist. The wavelength conversion particles may be, for example, a phosphor powder and/or quantum dots.

Referring to FIG. 23, areas, in which first wavelength conversion units are to be formed, are irradiated by light, for example, a mask layer 427 may be used to shield other areas. For example, ultraviolet light may be used for irradiation in a yellow light environment.

Further, the mask layer 427 is removed, and then the first wavelength conversion layer 4161 is developed using a developer. Because only areas of the first wavelength conversion units are light-cured, under an action of the developer, remaining parts are removed, so that multiple first wavelength conversion units 4161a are formed, as shown in FIG. 24. It is understood that the first wavelength conversion units 4161a fill at least some or all of the grid holes.

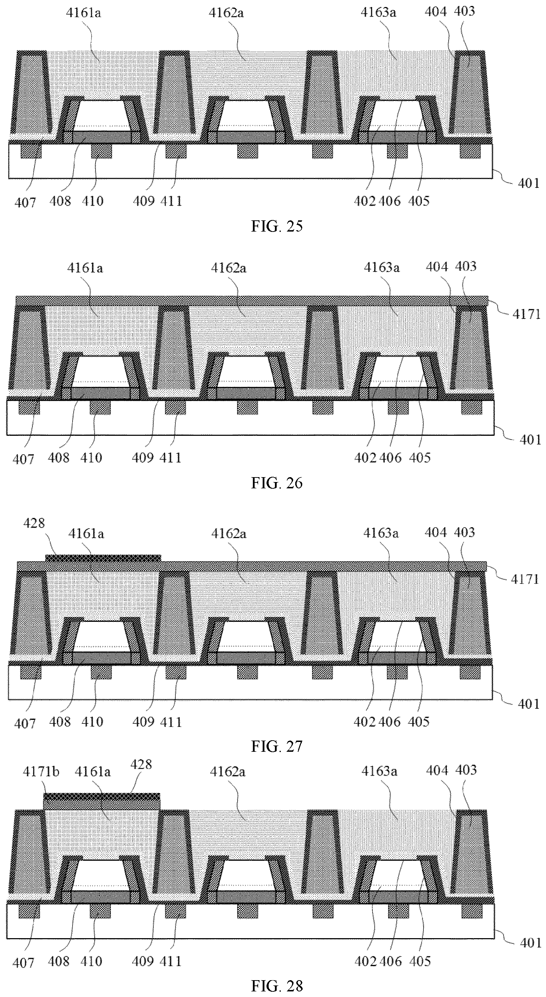

Similarly, multiple second wavelength conversion units 4162a and multiple third wavelength conversion units 4163a may further be formed in the grid structure, as shown in FIG. 25. It is understood that the first wavelength conversion units 4161a, the second wavelength conversion units 4162a, and the third wavelength conversion units 4163a fill corresponding recess areas, that is, filling different grid holes. That is, the first wavelength conversion units 4161a fill a part of the grid holes, the second wavelength conversion units 4162a fill a part of remaining grid holes, and the third wavelength conversion units 4163a fill all or part of remaining grid holes.

It is noted that the first wavelength conversion units 4161a may convert the first color light into the second color light. The second wavelength conversion units 4162a may convert the first color light into the third color light. The third wavelength conversion units 4163a may convert the first color light into the fourth color light.

In some embodiments, forming the filter layer 417 on the wavelength conversion layer 416 includes forming a first filter unit 4171b.

Referring to FIG. 26, a first filter layer 4171 may be formed on the wavelength conversion layer 416. A material of the first filter layer 4171 includes but is not limited to an organic color filter photoresist, a Bragg distributed reflector, and the like.

Referring to FIG. 27, a mask layer 428 may be provided on the first filter layer 4171. It is understood that the mask layer 428 covers a region corresponding to the region of the first wavelength conversion units 4161a.

Referring to FIG. 28, by etching the first filter layer 4171, the region of the filter layer that is not coved by the mask layer 428 are removed. For example, dry etching or wet etching may be used.

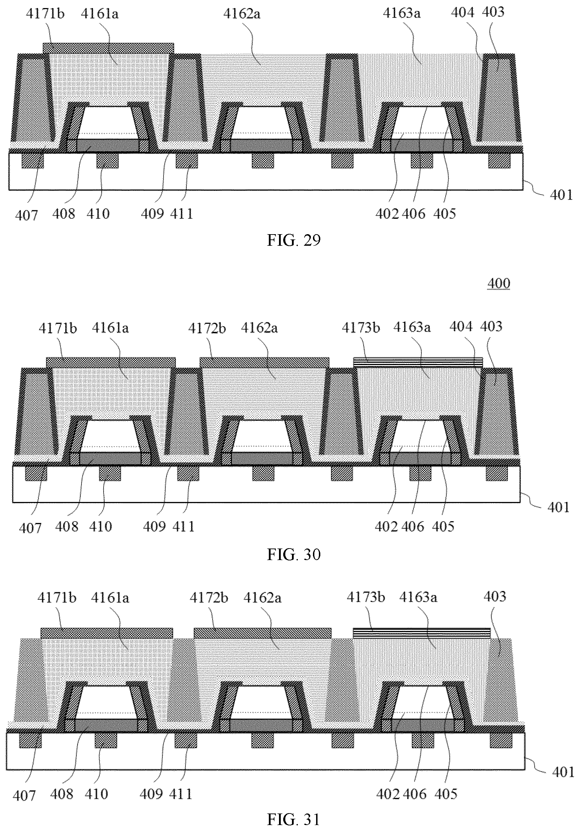

Referring to FIG. 29, the mask layer 28 is removed to form the first filter units 4171b. The first filter units 4171b is used to filter out other color light and allow the second color light to pass. Each first filter unit 4171b is corresponding to a respective first wavelength conversion unit 4161a.

Similarly, multiple second filter units 4172b and multiple third filter units 4173b may be further formed.

In some embodiments, if the reflective layer 404 is provided, the surface of the reflective layer 404 may be roughened before providing the wavelength conversion layer 416, to form a roughened surface. It is understood that the light reflecting capability may be increased by using the roughened reflective layer 404.

It is noted that a roughening manner of the reflective layer 404 is not specifically limited in this embodiment of the present application, for example, a corrosion roughening process may be performed on the reflective layer 404. For example, a material of the reflective layer 404 is Al, and the corrosion roughening process may be performed on the reflective layer 404 by using hydrochloric acid (that is, a hydrogen chloride solution).

In some embodiments, the reflective layer 404 may be not provided in the Micro LED micro-display chip. That is, after the grid structure 403 having multiple grid holes is formed, referring to FIG. 31, the first wavelength conversion units 4161a, the second wavelength conversion units 4162a, and the third wavelength conversion units 4163a may fill corresponding recess areas. Then, the first filter units 4171b, the second filter units 4172b, and the third filter units 4173b may be correspondingly provided on the first wavelength conversion units 4161a, the second wavelength conversion units 4162a, and the third wavelength conversion units 4163a to form a new Micro LED micro-display chip structure.

It is noted that in this embodiment of the present application, a step sequence of the foregoing method for manufacturing the Micro LED micro-display chip is not specifically limited.

It is noted that in this embodiment of the manufacturing method in the present application, only a manufacturing procedure or step is described. For a structure, a shape, a material, and the like that are not described, reference may be made to the foregoing embodiment of the Micro LED micro-display chip. Details are not described herein again.

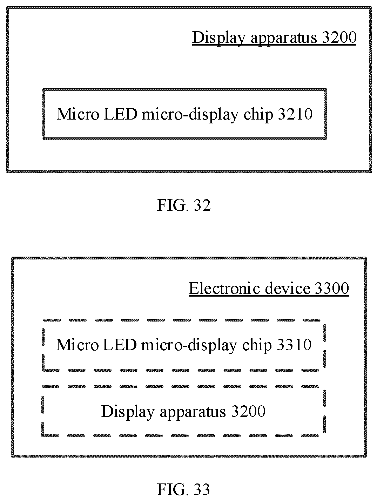

In another optional implementation of the present application, as shown in FIG. 32, an embodiment of the present application further provides a display apparatus 3200. The display apparatus 3200 includes a Micro LED micro-display chip 3210, and the Micro LED micro-display chip 3210 may be the Micro LED micro-display chip provided in any one of the foregoing embodiments. The display apparatus 3200 may be, for example, a component or a device including the Micro LED micro-display chip 3210, for example, may be a Micro LED micro-display chip device including an encapsulation layer.

As another optional implementation of the content disclosed in the present application, as shown in FIG. 33, an embodiment of the present application further provides an electronic device 3300. It is noted that a dotted line box in FIG. 33 indicates that the unit or module is optional. The electronic device 3300 may include, for example, a Micro LED micro-display chip 3310 or a display apparatus 3200. The Micro LED micro-display chip 3310 is the Micro LED micro-display chip provided in any one of the foregoing embodiments.

The electronic device 3300 in this embodiment of the present application includes but is not limited to: A display device such as an augmented reality (AR) display device, a virtual reality (VR) display device, a near-eye display (NED) device, and a head-up display (HUD) device.

The foregoing descriptions are merely specific implementations of the present disclosure, but are not intended to limit the protection scope of the present disclosure. Any variation or replacement readily figured out by a person skilled in the art within the technical scope disclosed in the present disclosure shall fall within the protection scope of the present disclosure. Therefore, the protection scope of this disclosure shall be subject to the protection scope of the claims.

## Claims

1. A Micro LED micro-display chip, comprising:
a driver panel;
a plurality of LED units arranged on the driver panel, wherein the plurality of LED units comprises a plurality of LED mesas in a one-to-one correspondence with the plurality of LED units, and each of the LED units is independently drivable by the driver panel;
a grid structure having a plurality of grid holes, wherein the plurality of grid holes are respectively provided around the plurality of LED mesas, and recess areas are formed between the LED mesas and the respective grid holes; and
a wavelength conversion layer provided on the grid structure, wherein the wavelength conversion layer comprises a first wavelength conversion layer, the first wavelength conversion layer comprises a plurality of first wavelength conversion units, the first wavelength conversion units fill the recess areas corresponding to the first wavelength conversion units , the LED units are configured to emit first color light, and the first wavelength conversion units are configured to convert the first color light into second color light.

2. The Micro LED micro-display chip according to claim 1, wherein a first filter layer is provided on the first wavelength conversion layer, and the first filter layer is configured to filter out other color light and pass the second color light.

3. The Micro LED micro-display chip according to claim 1, wherein the wavelength conversion layer further comprises a second wavelength conversion layer, the second wavelength conversion layer comprises a plurality of second wavelength conversion units, the second wavelength conversion units fill the recess areas corresponding to the second wavelength conversion units, and the second wavelength conversion units are configured to convert the first color light into third color light.

4. The Micro LED micro-display chip according to claim 3, wherein a second filter layer is provided on the second wavelength conversion layer, and the second filter layer is configured to filter out other color light and pass the third color light.

5. The Micro LED micro-display chip according to claim 3, wherein the wavelength conversion layer further comprises a third wavelength conversion layer, the third wavelength conversion layer comprises a plurality of third wavelength conversion units, the third wavelength conversion units fill the recess areas corresponding to the third wavelength conversion units, and the third wavelength conversion units are configured to convert the first color light into fourth color light.

6. The Micro LED micro-display chip according to claim 5, wherein a third filter layer is provided on the third wavelength conversion layer, and the third filter layer is configured to filter out other color light and pass the fourth color light.

7. The Micro LED micro-display chip according to claim 1, wherein a material of the wavelength conversion layer comprises wavelength conversion particles and a photoresist, and the wavelength conversion particles are phosphor powder and/or quantum dots.

8. The Micro LED micro-display chip according to claim 1, wherein a top surface of the wavelength conversion layer is flush with or lower than a top surface of the grid structure.

9. The Micro LED micro-display chip according to claim 1, wherein a reflective layer is provided on a surface of the grid structure, and the reflective layer is provided on side walls of the grid holes and a top surface of the grid structure.

10. The Micro LED micro-display chip according to claim 1, wherein a size of each of the LED units is in a range of 0.1-10 microns.

11. A method for manufacturing a Micro LED micro-display chip, comprising:
providing a driver panel;
forming a plurality of LED units on the driver panel, wherein the plurality of LED units comprises a plurality of LED mesas in a one-to-one correspondence with the plurality of LED units, and each of the LED units is independently drivable by the driver panel;
forming a grid structure having a plurality of grid holes, wherein the plurality of grid holes are respectively provided around the plurality of LED mesa, and recess areas are formed between the LED mesas and the respective grid holes; and
forming a wavelength conversion layer on the grid structure, wherein the wavelength conversion layer comprises a first wavelength conversion layer, the first wavelength conversion layer comprises a plurality of first wavelength conversion units, the first wavelength conversion units fill the recess areas corresponding to the first wavelength conversion units, the LED units are configured to emit first color light, and the first wavelength conversion units are configured to convert the first color light into second color light.

12. The method according to claim 11, wherein the forming the wavelength conversion layer on the grid structure comprises:
forming a first wavelength conversion material layer on the grid structure; and
performing exposure and development on the first wavelength conversion material layer according to a patterned mask to form the first wavelength conversion layer.

13. The method according to claim 11, wherein the method further comprises:
forming a first filter layer on the first wavelength conversion layer, wherein the first filter layer is configured to filter out other color light and pass the second color light.

14. The method according to claim 11, wherein the forming the wavelength conversion layer on the grid structure comprises:
forming a second wavelength conversion material layer on the grid structure; and
performing exposure and development on the second wavelength conversion material layer according to a patterned mask to form a second wavelength conversion layer,
wherein the second wavelength conversion layer comprises a plurality of second wavelength conversion units, the second wavelength conversion units fill the recess areas corresponding to the second wavelength conversion units, and the second wavelength conversion units are configured to convert the first color light into third color light.

15. The method according to claim 14, wherein the method further comprises:
forming a second filter layer on the second wavelength conversion layer, wherein the second filter layer is configured to filter out other color light and pass the third color light.

16. The method according to claim 14, wherein the forming the wavelength conversion layer on the grid structure comprises:
forming a third wavelength conversion material layer on the grid structure; and
performing exposure and development on the third wavelength conversion material layer according to a patterned mask to form a third wavelength conversion layer,
wherein the third wavelength conversion layer comprises a plurality of third wavelength conversion units, the third wavelength conversion units fill recess areas corresponding to the third wavelength conversion units, and the third wavelength conversion units are configured to convert the first color light into fourth color light.

17. The method according to claim 16, wherein the method further comprises:
forming a third filter layer on the third wavelength conversion layer, wherein the third filter layer is configured to filter out other color light and pass the fourth color light.

18. The method according to claim 11, wherein before the forming the wavelength conversion layer on the grid structure, the method further comprises:
forming a reflective layer on a surface of the grid structure having the plurality of grid holes.

19. The method according to claim 18, wherein the forming the reflective layer on the surface of the grid structure comprises:
forming a reflective material layer on the plurality of LED mesas and on the grid structure; and
etching the reflective material layer on the plurality of LED mesas to form the reflective layer on sidewalls of the grid holes and on a top surface of the grid structure.

20. The method according to claim 11, wherein the forming the plurality of LED units on the driver panel comprises:
forming an LED epitaxial layer on the driver panel; and
etching the LED epitaxial layer according to a pattern-mask designed MESA pattern, to form the plurality of LED units.
